(19) **Europäisches Patentamt / European Patent Office / Office européen des brevets**

(11) **EP 1 532 738 B1**

(12) **EUROPÄISCHE PATENTSCHRIFT**

(45) Veröffentlichungstag und Bekanntmachung des Hinweises auf die Patenterteilung:
**02.01.2008 Patentblatt 2008/01**

(21) Anmeldenummer: **03794862.7**

(22) Anmeldetag: **08.08.2003**

(51) Int Cl.:
**H03L 7/08** (2006.01)

(86) Internationale Anmeldenummer:
**PCT/EP2003/008844**

(87) Internationale Veröffentlichungsnummer:
**WO 2004/025836 (25.03.2004 Gazette 2004/13)**

(54) **VERFAHREN UND VORRICHTUNG ZUM ERFASSEN VON PERIODENDAUERSCHWANKUNGEN PERIODISCHER SIGNALE**

METHOD AND DEVICE FOR DETECTING PERIOD LENGTH FLUCTUATIONS OF PERIODIC SIGNALS

PROCEDE ET DISPOSITIF DE DETECTION DE VARIATIONS DE LA DUREE DE PERIODE DE SIGNAUX PERIODIQUES

(84) Benannte Vertragsstaaten:
**DE FR IT**

(30) Priorität: **26.08.2002 DE 10239099**

(43) Veröffentlichungstag der Anmeldung:
**25.05.2005 Patentblatt 2005/21**

(73) Patentinhaber: **Infineon Technologies AG
81669 München (DE)**

(72) Erfinder:
• **OBERLE, Hans-Dieter
82178 Puchheim (DE)**

• **SATTLER, Sebastian
81541 München (DE)**

(74) Vertreter: **Banzer, Hans-Jörg
Kraus & Weisert
Patent- und Rechtsanwälte
Thomas-Wimmer-Ring 15
80539 München (DE)**

(56) Entgegenhaltungen:
**DE-A- 3 615 952**

EP 1 532 738 B1

**Beschreibung**

Die vorliegende Erfindung betrifft ein Verfahren sowie eine Vorrichtung zum Erfassen von Periodendauerschwankungen eines periodischen ersten Signals und/oder eines periodischen zweiten Signals, wobei die Periodendauer des zweiten Signals kleiner als die des ersten Signals ist und eine Referenzanzahl von Perioden des zweiten Signals ermittelt wird, die während einer bestimmten Anzahl von Perioden des ersten Signals auftreten.

Bei periodischen Signalen treten nachteiligerweise auch Schwankungen der Periodendauer auf. Dies kann beispielsweise in der Digitaltechnik dazu führen, dass flankengesteuerte Vorgänge zu früh oder zu spät ausgelöst werden und Fehlfunktionen auftreten. Wenn beispielsweise bei einer seriellen Datenübertragung zur Datenrückgewinnung in einem festgelegten Takt der analoge Wert oder der digitale Zustand einer Leitung abgetastet werden muss, können Periodendauerschwankungen des Abtasttakts dazu führen, dass Fehler bei der Datenrückgewinnung auftreten, da die Abtastung zu einem falschen Zeitpunkt durchgeführt wird.

Zur Messung der Schwankungen der Periodendauer eines periodischen ersten Signals ist es bekannt, die Dauer einer Periode des ersten Signals wiederholt mit Hilfe eines periodischen zweiten Signals zu messen, dessen Periodendauer geringer als die Periodendauer des ersten Signals ist. Dabei wird eine Referenzanzahl von Perioden des zweiten Signals ermittelt, die während einer Periode des ersten Signals auftreten bzw. diese einer Periode einbeschrieben werden können. Die Periodendauer des ersten Signals entspricht dabei der Referenzanzahl multipliziert mit der Periodendauer des zweiten Signals. Dabei tritt ein Quantisierungsfehler auf, da die Periodendauer des ersten Signals nur mit einer ganzzahligen Anzahl von Perioden des zweiten Signals aufgelöst wird, wobei der Quantisierungsfehler mit sinkender Periodendauer des zweiten Signals sinkt. Weiterhin wirken sich auch Periodendauerschwankungen des zweiten Signals auf die Messung aus, wobei sich in Bezug auf das zweite Signal die akkumulierten Periodendauerschwankungen bemerkbar machen, das in einem Messzeitraum sich die Periodendauerschwankungen der Referenzanzahl an Perioden des zweiten Signals addieren. Die Periodendauerschwankungen des zweiten Signals wirken sich also umso stärker auf das Messergebnis aus, je größer die Referenzanzahl ist.

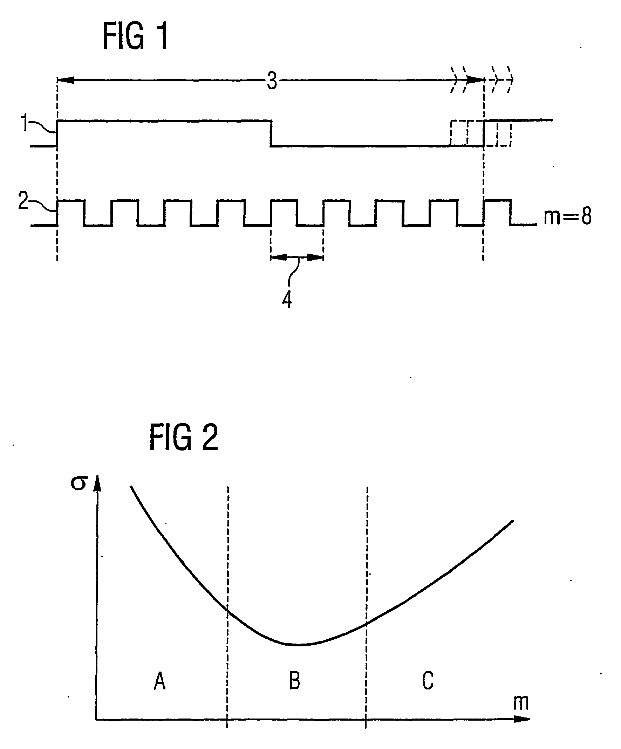

In Figur 1 ist das Grundprinzip dieses Messverfahrens dargestellt. Dabei wird eine Referenzanzahl m an Perioden des zweiten Signals 2 ermittelt, die in eine Periode des ersten Signals 1 einbeschrieben werden können. Die Periodendauer des ersten Signals 1 ist mit der Bezugsziffer 3 versehen und unterliegt Periodendauerschwankungen, die gestrichelt dargestellt sind. Um die Periodendauerschwankungen des ersten Signals 1 zu erfassen, wird bekannterweise ein Signal 2 mit sehr geringen Periodendauerschwankungen verwendet, so dass die Periodendauer von einzelnen Perioden des ersten Signals 1 mit hoher Genauigkeit gemessen werden kann. Wenn umgekehrt das Signal 1 mit einer hohen Genauigkeit und sehr geringen Periodendauerschwankungen vorliegt, können die akkumulierten bzw. aufsummierten Periodendauerschwankungen des zweiten Signals erfasst werden. Durch mehrfache Messungen von Referenzanzahlen m können somit die Periodendauerschwankungen des ersten Signals oder die akkumulierten Periodendauerschwankungen des zweiten Signals gemessen werden, abhängig davon, welches Signal mit hoher Genauigkeit bzw. mit geringen Periodenschwankungen vorliegt.

Nachteiligerweise erfordert dies jedoch zumindest ein hochgenaues Signal mit sehr geringer Periodendauerschwankung.

Die DE 36 15 952 A1 offenbart einen Taktgenerator mit geschlossener Regelschleife, welche eine Frequenzregelung aufweist. Hierzu erzeugen zwei Oszillatoren eines Frequenzdetektors Bezugsfrequenzen, welche weitaus niedriger sind als eine Frequenz eines von einem spannungsgesteuerten Oszillator des Taktgenerators erzeugten Signals. Die Frequenzen der beiden Oszillatoren des Frequenzdetektors unterscheiden sich voneinander. Mit Hilfe dieser Oszillatoren wird eine Anzahl von Perioden des Taktsignals, welches von dem spannungsgesteuerten Oszillator des Taktgenerators erzeugt wird, während eines kürzeren Zeitraums und eines längeren Zeitraums erfasst. Wenn die mittlere Frequenz, welche sich aus dem kürzeren Zeitraum ergibt, um mehr als 5% von einer Sollfrequenz abweicht, oder die mittlere Frequenz, welche sich aus dem längeren Zeitraum ergibt, um mehr als 1% von einer Sollfrequenz abweicht, wird ein entsprechendes Stellsignal erzeugt.

Der vorliegenden Erfindung liegt die Aufgabe zu Grunde, ein Verfahren sowie eine Vorrichtung zu schaffen, mit denen Periodendauerschwankungen eines periodischen ersten Signals durch Zählen einer einer Periode des ersten Signals einbeschreibbaren Referenzanzahl von Perioden eines höherfrequenten periodischen zweiten Signals mit geringem Aufwand zu schaffen, wobei keine hochgenauen Referenzsignale benötigt werden.

Erfindungsgemäß wird diese Aufgabe durch ein Verfahren mit den Merkmalen des Anspruchs 1 bzw. eine Vorrichtung mit den Merkmalen des Anspruchs 11 gelöst. Die Unteransprüche definieren jeweils bevorzugte und vorteilhafte Ausführungsformen der vorliegenden Erfindung.

Gemäß der vorliegenden Erfindung wird die Referenzanzahl von Perioden des zweiten Signals ermittelt, die einer oder mehrerer Perioden des ersten Signals einbeschreibbar sind. Die Messung dieser Referenzanzahl wird dabei für zwei verschiedene Periodendauern des zweiten Signals durchgeführt. Abhängig von der Periodendauer des zweiten Signals ändert sich auch die Referenzanzahl und der Einfluss der Periodendauerschwankungen des zweiten Signals auf die Genauigkeit der Messung.

In Figur 2 ist für ein erstes Signal mit einer gegebenen Periodendauer über die Referenzanzahl m die Standardabweichung σ mehrerer Messungen der Periodendauer des ersten Signals 1 durch Zählen einbeschreibbarer Perioden des zweiten Signals 2. Die Standardabweichung σ bezieht sich somit auf den Gesamtfehler der Messung, der sowohl von Periodendauerschwankungen des ersten Signals 1 als auch von der akkumulierten Periodendauerschwankung des zweiten Signals 2 abhängt. Die Referenzanzahl m ist proportional abhängig zum Kehrwert der Periodendauer 4 des zweiten Signals 2. Die Standardabweichung σ wird als Maß für die Periodendauerschwankungen herangezogen.

Der Verlauf in Figur 2 kann in drei Bereiche A bis C eingeteilt werden. Im Bereich A wird auf Grund der geringen Referenzanzahlen m der Verlauf der Standardabweichung im Wesentlichen durch den Quantisierungsfehler bestimmt, der proportional zur Periodendauer 4 des zweiten Signals 2 bzw. umgekehrt proportional zur Referenzanzahl m ist. Im Bereich A fällt der Verlauf der Standardabweichung mit steigenden Referenzanzahlen m und erreicht im Bereich B sein Minimum.

Im Bereich B wird die Standardabweichung sowohl durch die Periodendauerschwankungen des ersten Signals 1 als auch des zweiten Signals 2 bestimmt. Bei steigendem Wert der Periodendauerschwankungen des ersten Signals 1 wird der Verlauf im Bereich des Minimums angehoben und verflacht.

Anschließend steigt der Verlauf der Standardabweichung mit steigenden Referenzanzahlen m an. Der Verlauf in diesem Bereich verhält sich im Wesentlichen proportional zur Quadratwurzel der Referenzanzahl m.

Erfindungsgemäß wird nun die Messung mehrfach für zwei verschiedene Werte der Periodendauer 4 des zweiten Signals 2 durchgeführt. Für eine bestimmte Referenzanzahl m berechnet sich die Standardabweichung σ für die Gesamtmessung gemäß

$$\sigma^2 = a^2 + 2ay\rho + y^2$$

Für näherungsweise normal verteilte Periodendauerschwankungen $\sigma_1$ des ersten Signals 1 und $\sigma_2$ des zweiten Signals 2 kann ein Regressionskoeffizient r bestimmt werden gemäß

$$r = \rho \cdot x \quad,$$

wobei $x = y/a$, $y = \sigma_1$ und $a = \sigma_2 \cdot \sqrt{m}$ ist.

Die Berechnung der Standardabweichung σ für die gesamte Messung an den Stellen m0 und m > m0 führt auf die Gleichungen

$$\sigma = \sqrt{\sigma_0^2 + \sigma_2^2 m_0 \frac{m}{m_0}(1+2r)(1-A)}$$

und

$$\sigma = \sqrt{\sigma_0^2 / A - \sigma_1^2 (1-A)/A}$$

für die Periodendauerschwankungen der beiden Signale 1, 2 bzw. deren Standardabweichungen $\sigma_2 \cdot \sqrt{m_0}$ gleich den akkumulierten Periodendauerschwankungen des zweiten Signals 2 und die Periodendauerschwankungen bzw. die Standardabweichung des ersten Signals gleich σ1 in Abhängigkeit der gemessenen Größen $m_0$, $\sigma_0$ und m, σ. Der Regressionskoeffizient A ist zusammengesetzt aus den Regressionskoeffizienten $m_0$, $r_0$ und m, r. Dabei berechnet sich A

$$A = \left(\frac{m_0}{m}\right)\left(\frac{1+2r_0}{1+2r}\right)$$

Im folgenden sind für mehrere Verhältnisse von m zu $m_0$ die sich daraus ergebenden Regressionskoeffizienten angegeben.

| m/m0 | 1,69 | 2,0 | 2,47 | 4,0 |
|---|---|---|---|---|
| $\bar{r}$ $\bar{r}_0 = 0{,}1601$ | 0,0323 | 0,0189 | 0,0094 | 0,0009 |
| $\bar{A}$ | 0,7361 | 0,6387 | 0,5267 | 0, 331 |

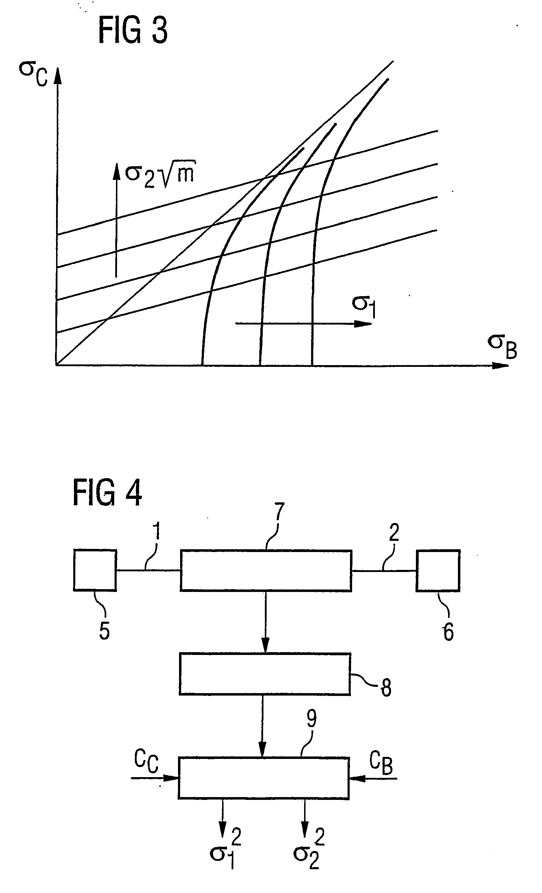

Zur Veranschaulichung ist in Figur 3 ein Diagramm dargestellt, in dem nach rechts die Standardabweichung $\sigma_B$ der Gesamtmessung für eine erste Periodendauer des zweiten Signals 2 und nach oben die Standardabweichung $\sigma C$ der Gesamtmessung für eine zweite geringere Periodendauer des Signals 2 aufgetragen ist. Ein bestimmter Punkt in diesem Diagramm gibt für bestimmte Werte der Standardabweichung $\sigma_1$ der Periodendauerschwankung des ersten Signals 1 und der akkumulierten Standardabweichung $\sigma_2 \sqrt{m}$ der Periodendauerschwankungen des zweiten Signals 2 die Werte für die Standardabweichungen $\sigma_B$ und $\sigma_C$ des Gesamtmessfehlers wieder, die sich bei Durchführung der Messung mit den zwei verschiedenen Periodendauern 4 des zweiten Signals 2 einstellen. In dem Diagramm sind beispielhaft zwei Gruppen von Linien eingezeichnet, die die Standardabweichungen der Gesamtmessung für die beiden Periodendauern des zweiten Signals 2 bei konstanter Standardabweichung $\sigma_1$ der Periodenschwankung des ersten Signals 1 bzw. bei konstanter Standardabweichung $\sigma_2 \sqrt{m}$ der akkumulierten Periodendauerschwankungen des zweiten Signals 2 darstellen.

Die im Wesentlichen waagrecht und gerade verlaufende Kurvenschar bezeichnet den Fall, dass die Standardabweichung der akkumulierten Periodendauerschwankungen des zweiten Signals 2 konstant ist, wobei mit dem nach oben gerichteten Pfeil, der mit $\sigma_2 \sqrt{m}$ gekennzeichnet ist, die Richtung angegeben ist, in der die Standardabweichung der akkumulierten Periodendauerschwankungen des zweiten Signals 2 ansteigt.

Die andere im Wesentlichen senkrecht verlaufende und oben gekrümmte Kurvenschar stellt den Fall dar, dass die Standardabweichung der Periodendauerschwankungen des ersten Signals 1 konstant ist, wobei der nach rechts gerichtete Pfeil, der mit $\sigma_1$ gekennzeichnet ist, die Richtung angibt, in der die Standardschwankungen der Periodendauer des ersten Signals 1 ansteigt. Zusätzlich ist eine durch den Ursprung gehenden im Wesentlichen winkelhalbierende Hilfsgerade eingezeichnet, deren Steigung der Kehrwert der Wurzel des Regressionskoeffizienten A ist und die die Asymptote für die Kurvenschar für konstante Standardabweichung $\sigma_1$ der Periodendauerschwankung des ersten Signals 1 darstellt.

Erfindungsgemäß können nun für 2 Werte $\sigma B$ und $\sigma C$ der Standardabweichung der Gesamtmessung für zwei verschiedene Periodendauern 4 des zweiten Signals 2 in dem Diagramm die Werte für die Standardabweichung der Periodendauerschwankungen des ersten Signals 1 sowie die Standardabweichung der akkumulierten Periodendauerschwankungen des zweiten Signals 2 abgelesen werden. Dazu werden aus den beiden Kurvenscharen die Kurven $\sigma_1$=konstant und $\sigma_2 \cdot \sqrt{m} = \mathrm{konstant}$ ausgewählt, deren Schnittpunkt den gewünschten Ort in der Ebene $\sigma B$, $\sigma C$ markiert. Diese Werte können auch rechnerisch bestimmt werden nach den Gleichungen

$$\sigma_{acc} = \sigma_2 \sqrt{m_0} = \sqrt{\frac{\sigma^2 - \sigma_0^2}{\dfrac{m}{m_0}(1+2r)(1-A)}}$$

$$\dot{\sigma}_1 = \sqrt{\frac{\sigma^2 A}{1-A}}$$

Mit Hilfe der Messung mit zwei verschiedenen Periodendauern des zweiten Signals 2 können somit die Periodendauerschwankungen sowohl des ersten Signals 1 sowie in akkumulierter Form des zweiten Signals 2 getrennt voneinander berechnet werden. Dies bedeutet, dass vorteilhafterweise kein hochgenaues Referenzsignal mit besonders geringen Periodendauerschwankungen erforderlich ist.

Auf diese Weise kann die Periodendauerschwankung des ersten Signals und/oder des zweiten Signals mit geringem Aufwand ermittelt werden, wodurch auch die kostengünstige Implementierung des erfindungsgemäßen Verfahrens als Selbsttestroutine in integrierten Halbleitern möglich wird. Beispielsweise bietet sich dies bei Phasenregelkreisen an, um die Periodendauerschwankungen des Ausgangssignals überprüfen zu können. Ein derartiger Phasenregelkreis kann beispielsweise bei der Datenübertragung zur Datenrückgewinnung beispielsweise in DSL-Datenübertragungssystemen eingesetzt sein.

Für die Durchführung des erfindungsgemäßen Verfahrens ist es grundsätzlich unerheblich, wie oft die Messung durchgeführt wird. Da es sich bei der Auswertung der Standardabweichung als Maß für Periodendauerschwankungen um ein statistisches Verfahren handelt, werden vorteilhafterweise die Messungen für die zwei verschiedenen Periodendauern des zweiten Signals 2 oft wiederholt, um zuverlässigere Werte zu erzielen. Das Verfahren kann dabei von einem Mikroprogramm gesteuert selbstständig in einem integrierten Schaltkreis oder einer entsprechenden Vorrichtung ablaufen, beispielsweise beim Einschalten.

Bislang ist der Fall beschrieben worden, dass die Messung für nur zwei verschiedene Periodendauern 4 für das zweite Signal 2 durchgeführt wird. Daneben ist es jedoch auch denkbar, für drei oder mehr verschiedene Werte für die Periodendauer 4 des zweiten Signals 2 die Messung durchzuführen, wodurch sich andere Gleichungen ergeben und sich u.U. ein überbestimmtes Gleichungssystem ergibt, aus dem eine Optimierungsaufgabe abgeleitet werden kann, bei der beispielsweise nach dem Verfahren der kleinsten Fehlerquadrate die Werte für die Periodendauerschwankung des.ersten Signals 1 und der akkumulierten Periodendauerschwankung des zweiten Signals 2 ermittelt werden können.

Die Erfindung wird nachfolgend anhand eines bevorzugten Ausführungsbeispiels unter Bezugnahme auf die beigefügte Zeichnung näher erläutert.

Figur 1 zeigt die zeitlichen Verläufe eines ersten und eines zweiten Signals mit verschiedenen Periodendauern,

Figur 2 zeigt den Verlauf der Standardabweichung der Messung der Periodendauer eines Signals mit Hilfe der Zählung von Perioden des zweiten Signals mit geringerer Periodendauer,

Figur 3 zeigt für verschiedene Kombinationen der Periodendauerschwankung des ersten und des zweiten Signals die sich bei Messung bei verschiedenen Periodendauern des zweiten Signals ergebenden Werte, und

Figur 4 zeigt den schematischen Schaltungsaufbau einer Vorrichtung zur Berechnung der Periodendauerschwankungen beider Signale.

In Figur 1 ist grundsätzlich der Verlauf eines periodischen ersten Signals 1 und eines periodischen zweiten Signals 2 dargestellt, wobei das erste Signal 1 eine Periodendauer 3 aufweist, die länger als die Periodendauer 4 des zweiten Signals 2 ist. Die Periodendauer 3 des ersten Signals 1 soll durch Auszählen der Perioden des zweiten Signals 2, die während der Periodendauer 3 des ersten Signals 1 auftreten, ermittelt werden. Die Anzahl dieser Perioden wird im folgenden als m bezeichnet. Im dargestellten Fall beträgt m = 8.

Die Periodendauer 3 des ersten Signals 1 ist dabei gewissen Schwankungen unterworfen, wie es gestrichelt angedeutet ist. Gleichermaßen unterliegt auch die Periodendauer 4 des zweiten Signals 2 gewissen Schwankungen, die in Figur 1 jedoch nicht dargestellt sind.

Im folgenden soll der Fall betrachtet werden, dass die mittlere Periodendauer des ersten Signals 1 im Wesentlichen konstant ist und mit Hilfe eines in der Periodendauer 4 einstellbaren zweiten Signals 2 gemessen werden soll. Bei Verringern der Periodendauer 4 des zweiten Signals 2 bzw. Erhöhen der Frequenz des zweiten Signals 2 erhöht sich notwendigerweise die Anzahl m, die als Referenzanzahl bezeichnet wird.

In Figur 2 ist der Verlauf des Fehlers bei dieser Periodendauermessung über die Referenzanzahl aufgetragen, die wiederum umgekehrt proportional zur Periodendauer 4 des zweiten Signals 2 ist. Als Maß für den Fehler bei der Ermittlung der Periodendauerschwankung nach dem vorgenannten Verfahren wird in Figur 2 und im folgenden die Standardabweichung σ des Messergebnisses aufgetragen, die sich bei wiederholter Durchführung der Messung ergibt.

In Figur 2 ist der Verlauf in drei Bereiche A, B, C aufgeteilt. Im Bereich A ist die Periodendauer 4 des zweiten Signals 2 hoch, so dass sich kleine Werte m ergeben und somit die Standardabweichung σ maßgeblich vom Quantisierungsfehler bestimmt wird, der sich umgekehrt proportional zur Referenzanzahl m verhält. Dementsprechend fällt der Verlauf für σ im Bereich A mit steigendem m. Im Bereich B besitzt der Verlauf der Standardabweichung ein Minimum, wobei in diesem Bereich die Standardabweichung im Wesentlichen gleichermaßen von den Periodendauerschwankungen des ersten Signals 1 als auch den Periodendauerschwankungen des zweiten Signals 2 abhängt. Im Falle der Periodendauerschwankungen des zweiten Signals 2 ist festzustellen, dass es sich immer um die akkumulierten Periodendauerschwankungen handelt, da während einer Messdauer mehrere Perioden des zweiten Signals 2 auftreten, deren Periodendauerschwankungen sich addieren.

Mit steigender Referenzanzahl m bzw. sinkender Periodendauer 4 des zweiten Signals 2 steigt im Bereich C der Verlauf der Standardabweichung wieder an, da bei hoher Referenzanzahl m bzw. hoher Anzahl gezählter Perioden des zweiten Signals 2 der Einfluss der Periodendauerschwankungen des zweiten Signals 2 zunimmt. In diesem. Bereich verhält sich der Verlauf ungefähr proportional zur Quadratwurzel der Referenzanzahl m.

Zur Durchführung der Messung werden nun zwei Periodendauern bestimmt, wobei die erste Periodendauer so bestimmt wird, dass die entsprechende Referenzanzahl m bei der Messung beim Minimum des Verlaufs der Standardabweichung σ im Bereich B liegt und der zweite Wert der Periodendauer geringer ist und im Bereich C liegt. Für die beiden Werte der Periodendauer 4 des zweiten Signals 2 wird nun die Periodendauermessung für das erste Signal 1 mehrfach durchgeführt und zwei Werte für die Standardabweichung σB und σC ermittelt, wobei σB der Wert der Standardabweichung ist, der für die im Bereich B liegende Referenzanzahl m ermittelt wurde. Entsprechendes gilt für den Wert σC.

In Figur 3 ist wie zuvor bereits beschrieben ein Diagramm dargestellt, dessen Ebene von den Werten für σB und für σC aufgespannt wird. In dieser Ebene sind anhand zweier beispielhafter Kurvenscharen die Orte angegeben, die sich in der Ebene von σB und σC für bestimmte Wertekombinationen für die Standardabweichung σ1 der Periodendauerschwankung des Signals 1 und die Standardabweichung $\sigma_2 \cdot \sqrt{m}$ der akkumulierten Periodendauerschwankungen des zweiten Signals 2 ergeben.

Die im Wesentlichen waagrecht und gerade verlaufende Kurvenschar bezeichnet die Ortskurven, auf denen die Standardabweichung $\sigma_2 \cdot \sqrt{m}$ der Periodendauerschwankung des zweiten Signals 2 konstant ist, wohingegen die im Wesentlichen senkrechte und oben gekrümmt verlaufende Kurvenschar die Orte angibt, auf denen die Standar- dabweichung $\sigma_1$ der Periodendauerschwankung des ersten Signals 1 konstant ist. Der nach rechts gerichtete und mit σ1 bezeichnete Pfeil gibt die Richtung an, in der die Kurven mit höherer Standardabweichung der Periodendauerschwankung des ersten Signals 1 liegen. Entsprechendes gilt für den nach oben gerichteten und mit $\sigma_2 \cdot \sqrt{m}$ bezeichneten Pfeil für steigende Werte der Standardabweichung der akkumulierten Periodendauerschwankung des zweiten Signals 2.

Zur graphischen Lösung kann in diesem in Figur 3 dargestellten Diagramm der Ort markiert werden, der sich aus den beiden gemessenen Werten für σB und σC für die beiden unterschiedlichen Periodendauern des zweiten Signals 2 ergibt. Anschließend wird ermittelt, welche zwei Kurven der beiden Kurvenscharen sich in diesem Ort schneiden und kann davon abhängig der Wert σ1 für die Standardabweichung der Periodendauerschwankungen des ersten Signals 1 und der Wert $\sigma_2 \cdot \sqrt{m}$ für die akkumulierten Periodendauerschwankungen des zweiten Signals 2 ermittelt werden.

In Figur 4 ist eine rechnerische Lösung dargestellt, wobei der Fall behandelt werden soll, dass das erste Signal 1 das Ausgangssignal eines Phasenregelkreises 5 ist und das zweite Signal 2 das Ausgangssignal eines Referenzoszillators 6 ist, dessen Periodendauer bzw. Frequenz eingestellt werden kann bzw. zumindest zwischen zwei Werte umgeschaltet werden kann. Von den beiden Signalen 1, 2 wird ein Zähler 7 beaufschlagt, der die Anzahl von Perioden des zweiten Signals 2 zählen kann, die in eine Periode des ersten Signals 1 einbeschreibbar sind bzw. während dieses Zeitraums auftreten. Der in Figur 4 dargestellten Schaltungsanordnung ist weiterhin eine nicht dargestellte Steuereinrichtung zugeordnet, die die verschiedenen Komponenten in geeigneter Weise ansteuert. Von dem Zähler 7 werden für die zwei verschiedenen Werte für die Periodendauer des zweiten Signals 2 die Messungen durchgeführt und an einen Statistikblock 8 weitergeleitet, in dem die statistische Auswertung erfolgt. Dazu wird in dem Statistikblock 8 für die zwei verschiedenen Periodendauern des zweiten Signals 2 jeweils die Standardabweichung der Messergebnisse bzw. der vom Zähler 7 ermittelten Zählerstände gebildet. Der Statistikblock 8 ermittelt somit die beiden Werte σB und σC, die er an eine Auswerteschaltung 9 weiterleitet. Diese berechnet aus den beiden Werten σB und σC die quadrierte Standar- dabweichung bzw. Varianz σ1$^2$ und σ2$^2$ für das erste Signal 1 bzw. das zweite Signal 2. Dabei wird im Auswerteblock 9 die Referenzanzahl m berücksichtigt und werden zusätzlich zwei Regressionskoeffizienten CB und CC herangezogen, die rechnerisch oder experimentell zuvor bestimmt worden sind und in der Vorrichtung hinterlegt sind.

Die in Figur 4 dargestellte Einrichtung kann beispielsweise in einem integrierten Schaltkreis implementiert sein und als Selbsttesteinheit bei jeder Inbetriebnahme des integrierten Schaltkreises eine Abschätzung der Periodendauerschwankungen des ersten Signals 1 des Phasenregelkreises 5 durchführen.

**Patentansprüche**

1. Verfahren zum Erfassen von Periodendauerschwankungen eines periodischen ersten Signals (1) und/oder eines periodischen zweiten Signals (2), wobei die Periodendauer (4) des zweiten Signals (2) kleiner als die Periodendauer (3) des ersten Signals (1) ist und eine erste Referenzanzahl (m0) von Perioden des zweiten Signals (2), die im Zeitraum einer Bezugsanzahl von Perioden des ersten Signals (1) auftreten, bei einer ersten Periodendauer des zweiten Signals (2) ermittelt wird,
   **dadurch gekennzeichnet,**
   **dass** eine zweite Referenzanzahl (m) von Perioden des zweiten Signals (2), die im Zeitraum einer Bezugsanzahl von Perioden des ersten Signals (1) auftreten, bei einer zweiten, von der ersten Periodendauer verschiedenen Periodendauer des zweiten Signals (2) ermittelt wird, und abhängig von der ersten und zweiten Referenzanzahl (m, m0) ein Maß für die Periodendauerschwankung des ersten Signals (1) und/oder des zweiten Signals (2) ermittelt wird.

2. Verfahren nach Anspruch 1,
   **dadurch gekennzeichnet,**
   **dass** die Referenzanzahlen (m0, m) mehrmals ermittelt werden.

3. Verfahren nach Anspruch 2,
   **dadurch gekennzeichnet,**
   **dass** als Maß für die Periodendauerschwankung eines Signals (1, 2) die Standardabweichung von Periodendauern des Signals (1, 2) ermittelt wird.

4. Verfahren nach einem der vorhergehenden Ansprüche,
   **dadurch gekennzeichnet,**
   **dass** die erste Periodendauer des zweiten Signals (2) derart gewählt ist, dass der Einfluss der Periodendauerschwankung des ersten Signals (1) größer als der Einfluss der Periodendauerschwankung des zweiten Signals auf die erste Referenzanzahl (m0) ist.

5. Verfahren nach einem der vorhergehenden Ansprüche,
   **dadurch gekennzeichnet,**
   **dass** die zweite Periodendauer des zweiten Signals (2) derart gewählt ist, dass der Einfluss der Periodendauerschwankung des ersten Signals (1) kleiner als der Einfluss der Periodendauerschwankung des zweiten Signals (2) auf die zweite Referenzanzahl (m) ist.

6. Verfahren nach einem der vorhergehenden Ansprüche,
   **dadurch gekennzeichnet,**
   **dass** die Bezugsanzahl von Perioden des ersten Signals (1) 1 ist.

7. Verfahren nach einem der vorhergehenden Ansprüche,
   **dadurch gekennzeichnet,**
   **dass** das erste Signal (1) das Ausgangssignal eines Phasenregelkreises (5) ist und das zweite Signal (2) das Ausgangssignal eines Referenzoszillators (6) ist.

8. Verfahren nach einem der vorhergehenden Ansprüche,
   **dadurch gekennzeichnet,**
   **dass** das Verfahren als Selbsttest in einem integrierten Halbleiter durchgeführt wird.

9. Verfahren nach einem der vorhergehenden Ansprüche,
   **dadurch gekennzeichnet,**
   **dass** zu Beginn der Ermittlung einer Referenzanzahl (m0, m) das erste Signal (1) und das zweite Signal (2) in Phase sind.

10. Verfahren nach einem der vorhergehenden Ansprüche,

**dadurch gekennzeichnet,**
**dass** die Periodendauerschwankung des ersten Signals (1) und/oder des zweiten Signals (2) zusätzlich in Abhängigkeit von zuvor ermittelten Regressionskoeffizienten (CA, CB) ermittelt wird.

**11.** Vorrichtung zum Erfassen von Periodendauerschwankungen eines periodischen ersten Signals (1) und/oder eines periodischen zweiten Signals (2), wobei die Periodendauer (4) des zweiten Signals (2) kleiner als die Periodendauer (3) des ersten Signals (1) ist und die Vorrichtung derart eingerichtet ist, dass sie eine erste Referenzanzahl (m0) von Perioden des zweiten Signals (2), die im Zeitraum einer Bezugsanzahl von Perioden des ersten Signals (1) auftreten, bei einer ersten Periodendauer des zweiten Signals (2) ermitteln kann,
**dadurch gekennzeichnet,**
**dass** die Vorrichtung derart eingerichtet ist, dass sie eine zweite Referenzanzahl (m) von Perioden des zweiten Signals (2), die im Zeitraum einer Bezugsanzahl von Perioden des ersten Signals (1) auftreten, bei einer zweiten, von der ersten Periodendauer verschiedenen Periodendauer des zweiten Signals (2) ermitteln kann und abhängig von der ersten Referenzanzahl (m0) und der zweiten Referenzanzahl (m) ein Maß für die Periodendauerschwankung des ersten Signals (1) und/oder des zweiten Signals (2) ermitteln kann.

**12.** Vorrichtung nach Anspruch 10,
**dadurch gekennzeichnet,**
**dass** die Vorrichtung einen Referenzoszillator (6) zum Erzeugen des zweiten Signals (2) aufweist.

**13.** Vorrichtung nach Anspruch 10 oder 11,
**dadurch gekennzeichnet,**
**dass** die Vorrichtung einen Phasenregelkreis (5) aufweist und derart eingerichtet ist, dass das Ausgangssignal des Phasenregelkreises (5) das erste Signal (1) ist.

**14.** Vorrichtung nach einem der Ansprüche 10 bis 12,
**dadurch gekennzeichnet,**
**dass** die Vorrichtung ein integrierter Halbleiter ist.

**15.** Vorrichtung nach einem der Ansprüche 10 bis 13,
**dadurch gekennzeichnet,**
**dass** die Vorrichtung zur Durchführung eines Verfahrens nach einem der Ansprüche 1 bis 9 eingerichtet ist.

**Claims**

**1.** Method for detecting period length fluctuations of a periodic first signal (1) and/or of a periodic second signal (2), wherein the period length (4) of the second signal (2) is shorter than the period length (3) of the first signal (1) and a first reference number (m0) of periods of the second signal (2), which arise in the time-span of a reference number of periods of the first signal (1) is determined for a first period length of the second signal (2), **characterised in that** a second reference number (m) of periods of the second signal (2) which arise in the time-span of a reference number of periods of the first signal (1) is determined for a second period length, different from the first period length, of the second signal (2), and dependent on the first and second reference numbers (m, m0) a measure for the period length fluctuation of the first signal (1) and/or of the second signal (2) is calculated.

**2.** Method according to Claim 1, **characterised in that** the reference numbers (m0, m) are determined several times.

**3.** Method according to Claim 2, **characterised in that** as a measure for the period length fluctuation of a signal (1, 2) the standard deviation of period lengths of the signal (1, 2) is determined.

**4.** Method according to any one of the preceding claims, **characterised in that** the first period length of the second signal (2) is selected in such a manner that the effect of the period length fluctuation of the first signal (1) is greater than the effect of the period length fluctuation of the second signal on the first reference number (m0).

**5.** Method according to any one of the preceding claims, **characterised in that** the second period length of the second signal (2) is selected in such a manner that the effect of the period length fluctuation of the first signal (1) is less than the effect of the period length fluctuation of the second signal (2) on the second reference number (m).

6. Method according to any one of the preceding claims, **characterised in that** the reference number of periods of the first signal (1) is 1.

7. Method according to any one of the preceding claims, **characterised in that** the first signal (1) is the output signal of a phase-locked loop (5) and the second signal (2) is the output signal of a reference oscillator (6).

8. Method according to any one of the preceding claims, **characterised in that** the method is carried out in an integrated semiconductor as a self-test.

9. Method according to any one of the preceding claims, **characterised in that** at the start of determining a reference number (m0, m) the first signal (1) and the second signal (2) are in phase.

10. Method according to any one of the preceding claims **characterised in that** the period length fluctuation of the first signal (1) and/or of the second signal (2) is additionally determined dependent on previously calculated regression coefficients (CA, CB).

11. Apparatus for detecting period length fluctuations of a periodic first signal (1) and/or a periodic second signal (2), wherein the period length (4) of the second signal (2) is shorter than the period length (3) of the first signal (1) and the apparatus is designed in such a way that it can determine a first reference number (m0) of periods of the second signal (2), which arise in the time-span of a reference number of periods of the first signal (1) for a first period length of the second signal (2), **characterised in that** the apparatus is designed in such a way that it can determine a second reference number (m) of periods of the second signal (2) which arise in the time-span of a reference number of periods of the first signal (1) for a second period length, different from the first period length, of the second signal (2), and dependent on the first reference number (m0) and the second reference number can determine a measure for the period length fluctuation of the first signal (1) and/or of the second signal (2).

12. Apparatus according to Claim 10, **characterised in that** the apparatus has a reference oscillator (6) for producing the second signal (2).

13. Apparatus according to Claim 10 or 11, **characterised in that** the apparatus has a phase-locked loop (5) and is designed in such a way that the output signal of the phase-locked loop (5) is the first signal (1).

14. Apparatus according to any one of Claims 10 to 12, **characterised in that** the apparatus is an integrated semiconductor.

15. Apparatus according to any one of Claims 10 to 13, **characterised in that** the apparatus is designed for carrying out a method according to any one of Claims 1 to 9.

**Revendications**

1. Procédé de détection de variations de la durée de période d'un premier signal périodique (1) et/ou d'un deuxième signal périodique (2), la durée de période (4) du deuxième signal (2) étant inférieure à la durée de période (3) du premier signal (1) et un premier nombre de référence (m0) de périodes du deuxième signal (2) se produisant dans le laps de temps d'un nombre de référence de périodes du premier signal (1) étant calculé lors d'une première durée de période du deuxième signal (2), **caractérisé en ce qu'**un deuxième nombre de référence (m) de périodes du deuxième signal (2) apparaissant dans le laps de temps d'un nombre de référence de périodes du premier signal (1) est calculé dans le cas d'une deuxième durée de période du deuxième signal (2) différente de la première et en ce qu'une cote est calculée en fonction du premier et du deuxième nombre de référence (m, m0) pour la variation de durée de la période du premier signal (1) et/ou du deuxième signal (2).

2. Procédé selon la revendication 1, **caractérisé en ce que** les nombres de référence (m0, m) sont calculés plusieurs fois.

3. Procédé selon la revendication 2, **caractérisé en ce**

**que** l'écart standard des durées de période du signal (1, 2) est calculé comme cote pour la variation de la durée de période d'un signal (1, 2).

4. Procédé selon l'une quelconque des revendications précédentes,
   **caractérisé en ce**
   **que** la première durée de période du deuxième signal (2) est choisie de manière à ce que l'influence de la variation de durée de la période du premier signal (1) soit supérieure à l'influence de la variation de durée de période du deuxième signal sur le premier nombre de référence (m0).

5. Procédé selon l'une quelconque des revendications précédentes,
   **caractérisé en ce**
   **que** la deuxième durée de la période du deuxième signal (2) est sélectionnée de manière à ce que l'influence de la variation de durée de période du premier signal (1) soit inférieure à l'influence de la variation de la durée de période du deuxième signal (2) sur le deuxième nombre de référence (m).

6. Procédé selon l'une quelconque des revendications précédentes,
   **caractérisé en ce**
   **que** le nombre de référence des périodes du premier signal (1) est 1.

7. Procédé selon l'une quelconque des revendications précédentes,
   **caractérisé en ce**
   **que** le premier signal (1) est le signal de sortie d'un circuit de régulation de phase (5) et que le deuxième signal (2) est le signal de sortie d'un oscillateur de référence (6).

8. Procédé selon l'une quelconque des revendications précédentes,
   **caractérisé en ce**
   **que** le procédé est réalisé sous forme d'auto-test dans un semi-conducteur intégré.

9. Procédé selon l'une quelconque des revendications précédentes,
   **caractérisé en ce**
   **qu'**au début du calcul d'un nombre de référence (m0, m), le premier signal (1) et le deuxième signal (2) sont en phase.

10. Procédé selon l'une quelconque des revendications précédentes,
    **caractérisé en ce**
    **que** la variation de la durée de période du premier signal (1) et/ou du deuxième signal (2) est calculée en complément en fonction du coefficient de régression (CA, CB) calculé auparavant.

11. Dispositif de détection de variations de la durée de période d'un premier signal périodique (1) et/ou d'un deuxième signal périodique (2), la durée de période (4) du deuxième signal (2) étant inférieure à la durée de période (3) du premier signal (1) et le dispositif étant disposé de telle manière qu'il puisse calculer un premier nombre de référence (m0) des périodes du deuxième signal (2) apparaissant dans le laps de temps d'un nombre de référence des périodes du premier signal (1) lors d'une première durée de période du deuxième signal (2),
    **caractérisé en ce**
    **que** le dispositif est installé de manière à pouvoir calculer un deuxième nombre de référence (m) des périodes du deuxième signal (2) apparaissant dans le laps de temps d'un nombre de référence de périodes du premier signal (1) dans le cas d'une deuxième durée de période du deuxième signal (2) différente de la première durée de période ainsi qu'une cote pour la variation de la durée de période du premier signal (1) et/ou du deuxième signal (2) en fonction du premier nombre de référence (m0) et du deuxième nombre de référence (m).

12. Dispositif selon la revendication 10,
    **caractérisé en ce**
    **que** le dispositif présente un oscillateur de référence (6) pour générer le deuxième signal (2).

13. Dispositif selon la revendication 10 ou 11,
    **caractérisé en ce**
    **que** le dispositif présente un circuit de régulation de phases (5) et est installé de manière à ce que le signal de sortie du circuit de régulation de phases (5) soit le premier signal (1).

**14.** Dispositif selon l'une quelconque des revendications 10 à 12, **caractérisé en ce que** le dispositif est un semi-conducteur intégré.

**15.** Dispositif selon l'une quelconque des revendications 10 à 13, **caractérisé en ce que** le dispositif est installé pour réaliser un procédé selon l'une quelconque des revendications 1 à 9.

FIG 1

m=8

FIG 2

FIG 3

FIG 4

**EP 1 532 738 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3615952 A1